(19) Europäisches Patentamt

European Patent Office

Office européen des brevets

(11) **EP 4 734 371 A1**

(12) **EUROPEAN PATENT APPLICATION**

(43) Date of publication:
**29.04.2026 Bulletin 2026/18**

(21) Application number: **24208625.4**

(22) Date of filing: **24.10.2024**

(51) International Patent Classification (IPC):
**H03K 17/12** (2006.01)    **H03K 17/16** (2006.01)

(52) Cooperative Patent Classification (CPC):
**H03K 17/122; H03K 17/127; H03K 17/166;**
H03K 2217/0027

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Epinovatech AB**
**223 63 Lund (SE)**

(72) Inventor: **OLSSON, Martin Andreas**
**223 63 Lund (SE)**

(74) Representative: **Zacco Sweden AB**
**P.O. Box 5581**
**Löjtnantsgatan 21**
**114 85 Stockholm (SE)**

(54) **DRIVE CIRCUIT FOR POWER CONVERTERS**

(57)    The present invention relates to a drive circuit for a power converter. The drive circuit comprises: a first transistor and a second transistor electrically connected in parallel having a common power input and individual gates; a first variable gate voltage controller connected to the gate of the first transistor; a second variable gate voltage controller connected to the gate of the second transistor; and control circuitry configured to independently control an impedance of the first and second variable gate voltage controllers based on a current through the respective first and second transistor to control the current through the respective transistor.

## Fig. 1

## Description

Technical field

The present invention relates to a drive circuit configured to control distribution of current through a pair of transistors.

Background

Power converters are implemented in modern day power systems to convert between voltage levels.

The current transistor-based converters in the state of the art provide a low current rating per transistor and are often required to be coupled in parallel for handling higher currents. This is especially true for the case of power transmission networks and charging of electrical vehicles as well as kilowatt power delivery.

In theory, parallel coupled components which all share the same electrical parameters will evenly share the current, this is however not always the case in practice. The internal connection between the transistors provides an impedance, which results in a difference of the electrical parameters that individual transistors receive. In theory, an uneven current sharing between transistors may even out due to a positive temperature coefficient in the resistance of conducting materials, this is however not always possible in high frequency converters, as the transistors don't reach a steady state before being switched to a non-conducting state, and due manufacturing deviations of electrical tolerances of individual GaN power devices.

There is therefore a need for an improved control of the current sharing between transistors.

Summary of the invention

It is an object to mitigate, alleviate or eliminate one or more of the above-identified deficiencies in the art and disadvantages singly or in any combination and solve at least the above-mentioned problem.

According to a first aspect a drive circuit for a power converter is presented. The drive circuit comprises a first transistor and a second transistor electrically connected in parallel having a common power input and individual gates; a first variable gate voltage controller connected to the gate of the first transistor; a second variable gate voltage controller connected to the gate of the second transistor; and control circuitry configured to independently control an impedance of the first and second variable gate voltage controllers based on a current through the respective first and second transistor to control the current through the respective first and second transistor.

By impedance is meant an electrical property comprising a reactance and a resistance. The impedance may also be referred to as a complex impedance. The impedance may be represented in cartesian form, referring to the resistance representing a real part, and the reactance representing an imaginary part. The impedance may also be represented in polar form, where a vector is created using the values of the cartesian form, the amplitude of the vector is equal to the total impedance.

As discussed above, parallelly arranged transistors may result in uneven sharing of current from a common input. This may lead to degraded electrical and thermal performance, limiting the effectiveness of paralleling transistors. To evaluate the current distribution in parallel transistors it is proposed to measure the current going through the individual transistors. However, obtaining the waveforms of the current at high frequencies without disturbing the behavior of the circuit is challenging. The present invention is addressing this by controlling the gate voltage of the respective first and second transistor in a feedback loop as presented herein. Especially, by independently controlling the impedance of the first and second variable gate voltage controllers based on the current through the respective first and second transistor to control the current through the respective transistor facilitates a way of controlling the rise time and fall time of the gate voltage of the respective first and second transistor. The drive circuit presented herein allow to combine multiple GaN HEMT transistors to appear and operate as a single ON-resistance and with lower ON-resistance allowing for increased power handling capability and higher total efficiency.

The control circuitry may independently control the impedance of the first and second variable gate voltage controllers by controlling a respective resistance of the first variable gate voltage controller and second variable gate voltage controller.

The resistance of the variable gate voltage controller may be controlled to allow reduction of the difference between the current going through the individual transistor. This may therefore enable a better utilization of transistors coupled in parallel, and thus increase current rating of a power converter compared to a power converter with current sharing issues between transistors.

The resistance of the first and second variable gate voltage controllers may be controlled such that a difference between the respective current through the first and second transistor is minimized.

The first transistor and the second transistor may be GaN-based transistors. GaN-based transistors facilitate a steady threshold voltage over a wide temperature range. Additionally, GaN-based transistors comprise a positive temperature coefficient of the ON-resistance, this allows for further current sharing between transistors due to an elevated heat loss of a transistor conducting more current than neighboring transistors. The elevated heat loss increases the temperature of the junction resulting in an increased resistance.

The inventor has realized that rather than limiting the frequency and slowing down the transistors it is possible to dynamically control the current sharing between parallel transistors, especially for GaN-based transistors. Doing so increases the efficiency of the circuit and enable current sharing without faulty operation. This is especially applicable for switching frequency above 200 kHz. And more especially during converter turn-on events where each transistor may have a dynamic ON-resistance. Hence, the first transistor and the second transistor may each have a switching frequency above 200 kHz. Implementation of a drive circuit having transistors switching at frequencies above 200 kHz allows for less ripple on the output voltage, as the reactive components, such as an output capacitor and inductor, have less time to discharge. This is especially useful for power converters. In some implementations the first transistor and the second transistor may each have a switching frequency above 500 kHz. The switching frequency of the converter and the first transistor and the second transistor may even be as high as in a range of 1-10 MHz. It should be understood that the maximum frequency of the transistors is given by the rise time plus fall time e.g. a few nanoseconds of the individual transistors.

The first transistor and the second transistor may comprise a common input contact monolithically. Having a first transistor and a second transistor with a common input contact monolithically facilitates a reduction of parasitic inductances of bond wires between transistors. Each of the transistors may be isolated from each other by ion-implantation causing the transistor to become resistive.

The control circuitry may comprise a first PID regulator and a second PID regulator, wherein the first PID regulator is configured to control the resistance of the first variable gate voltage controller based on the current through the first transistor and wherein the second PID regulator is configured to control the resistance of the second variable gate voltage controller based on the current through the second transistor. Implementation of a PID regulator in a drive circuit to control the variable gate voltage controller of a respective transistor allows controlling the impedance of the variable gate controller with a higher sensitivity. Controlling the impedance of the variable gate controller with a higher sensitivity may facilitate finetuning of current sharing between parallel transistors. The PID regulator may be digital, but may also be made by using analog components, such as OpAmps.

The PID regulator may comprise four operational amplifiers, wherein three of the four operational amplifiers comprise a common input and wherein one of the four operational amplifiers comprise an input receiving an output of each one of the three operational amplifiers and an output to control the respective first and second variable gate voltage controller.

The drive circuit may further comprise a junction temperature sensor configured to measure a first junction temperature of a first junction of the first transistor and a second junction temperature of a second junction of the second transistor. The current through the first transistor may be determined based on the first junction temperature and the current through the second transistor may be determined based on the second junction temperature. Determining the current through the first transistor and the second transistor based on their respective junction temperatures allows for a current reading without implementing components introducing a heat loss, which in results reduced heat loss of the drive circuit. A higher efficiency may therefore be achievable.

The drive circuit may further comprise an output current sensor configured to determine the current through the first transistor and the current through the second transistor. The output current sensor may comprise a thermistor.

The drive circuit may further comprise an input current sensor configured to determine the current through the first transistor and the current through the second transistor.

The drive circuit may further comprise a first gate drive transformer and a second gate drive transformer. The first and second gate drive transformers may be configured to independently charge a respective gate voltage of the first transistor and the second transistor. Charging a gate voltage of the first transistor and the second transistor by a respective gate drive transformer facilitates a protection of low voltage electronics from one side of the gate drive transformer from any damage due to faults on the other side of the gate drive transformer.

The first and second gate drive transformers may each comprise a primary winding and a secondary winding. The respective primary and secondary winding of the first and second gate drive transformers may be wound on a common magnetic core.

The first and second gate drive transformers may each comprise a primary side coupling capacitor and a secondary side coupling capacitor configured for blocking Direct Current voltage across the respective gate drive transformer.

The drive circuit may further comprise a primary resistor and a Zener diode configured for protecting the first transistor and the second transistor from overvoltage.

According to a second aspect, a power converter system is presented. The power converter system comprises the drive circuit according to the first aspect.

The above-mentioned features and possible advantages of the first aspect, when applicable, apply to this second aspect as well. To avoid undue repetition, reference is made to the above.

According to a third aspect, a power module is presented. The power module comprises one or more power converter systems according to the second aspect.

The above-mentioned features and possible advantages of the first aspect, when applicable, apply to this third aspect as well. To avoid undue repetition, reference is made to the above.

A further scope of applicability will become apparent from the detailed description given below. However, it should be understood that the detailed description and specific examples are given by way of illustration only.

It is to be understood that the terminology used herein is for purpose of describing particular embodiments only and is not intended to be limiting. It must be noted that, as used in the specification and the appended claim, the articles "a", "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

Brief description of the drawings

The above and other aspects will now be described in more detail, with reference to appended figures. The figures should not be considered limiting; instead, they are used for explaining and understanding.

As illustrated in the figures, the sizes of layers and regions may be exaggerated for illustrative purposes. Like reference numerals refer to like elements throughout.

Fig. 1 is a circuit diagram illustrating a drive circuit for two transistors comprising a gate voltage controller for each respective transistor.

Figs 2-4 are circuit diagrams illustrating various types of current measurements of a current through the first and second transistor, respectively.

Fig. 5 illustrates a boost converter comprising a drive circuit as discussed in connection with one or more of Figs 1-4.

Fig. 6 is a circuit diagram illustrating an example of the control circuitry comprising a PID controller for a first and a second transistor.

Fig. 7 is a circuit diagram illustrating an example of the control circuitry comprising a PID controller implemented with analog components for a first and a second transistor.

Fig. 8 is a circuit diagram illustrating that charging of the respective gate may be implemented with a respective gate drive transformer.

Detailed description

The present invention will now be described more fully hereinafter with reference to the accompanying drawings, in which currently preferred embodiments of the invention are shown. This invention may, however, be embodied in many different forms.

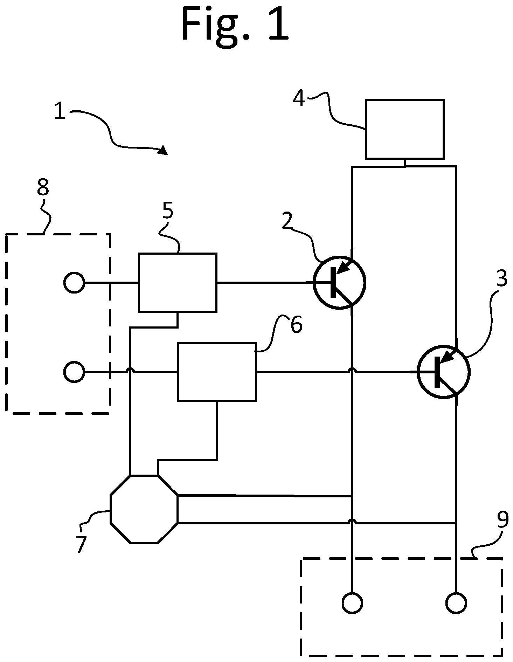

Fig. 1 illustrates circuit diagram of a drive circuit 1. The drive circuit comprises a first transistor 2 and a second transistor 3. The first transistor 2 and the second transistor 3 has a common power input 4. The common power input 4 is connected to each respective transistor 2,3 on a respective source node thereof. The first transistor 2 and the second transistor 3 further has a respective drain node connected to a transistor output 9. The first transistor 2 and second transistor 3 are therefore coupled in parallel between the power input 4 and transistor output 9. A respective current from the power input 4, through the first transistor 2 and second transistor 3 to the transistor output 9 is conducted when a respective gate voltage of the first transistor 2 and second transistor 3 is in an ON state. The respective gate voltage is supplied by a gate input 8. Supply of the respective gate voltage is controlled by a first gate voltage controller 5 for the first transistor 2 and a second gate voltage controller 6 for the second transistor 3, respectively. The first gate voltage controller 5 and the second gate voltage controller 6 each comprises a controllable impedance. The respective controllable impedance is controlled by a control circuitry 7. The controlling of the respective controllable impedance is based on a current running through each respective first transistor 2 and second transistor 3. Hence, the control circuitry 7 is configured to control the impedance of the first gate voltage controller 5 and the impedance of the second gate voltage controller 6 independently. This in order to control a rise and fall time for the gate voltage of the respective first transistor 2 and second transistor 3. Controlling the rise and fall time for the gate voltages allows for further control and fine tuning of the current conducted between the power input 4 and the transistor output 9 for the respective first transistor 2 and second transistor 3. Ultimately, the control circuitry 7 is configured to control the impedance of the first and second variable gate voltage controllers 5, 6 such that a difference between the respective current through the first and second transistor 2, 3 is minimized. A feedback loop is therefore created between the current conducted through each respective transistor 2,3 and their respective gate voltage controllers 5,6.

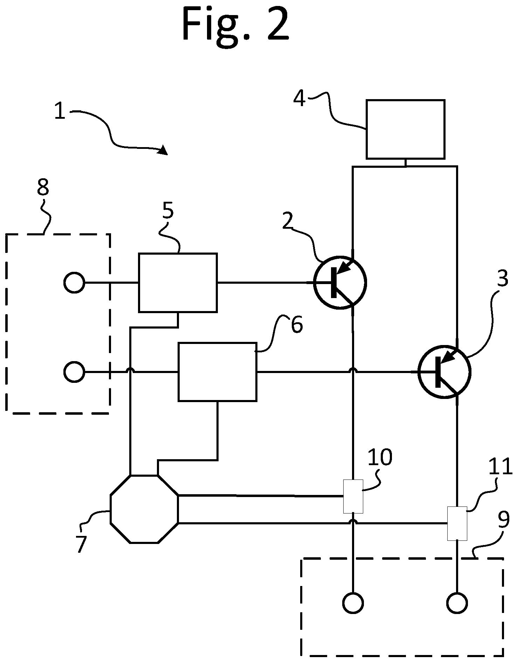

The current running through each respective first transistor 2 and second transistor 3 may be determined using different types of measurements. In connection with Figs 2-4 some types of current measurements for determining the current through the first transistor 2 and the second transistor 3, respectively, will be discussed. In connection with each of Figs 2-4 one specific type of current measurement is used for both first and second transistor 2,3. It is to be understood, that these types of current measurements are not excluding each other, and a combination may be used. The combinations may be so that one type of current measurement may be used for one of the first and second transistors 2, 3 while another type of current measurement may be used for the other one of the first and second transistors 2, 3. It is also to be understood that a combination of types of current measurement may be used for the same transistor.

As illustrated in connection with Fig. 2 the current through the respective first and second transistor 2, 3 may be measured using an output current sensor. The output current sensor may comprise a first output current sensor 10 connected on a connection between the first transistor 2 and the transistor output 9 and a second output current sensor 11 connected on a connection between the second transistor 3 and the transistor output 9. The first output current sensor 10 is configured to measure the current conducted between the power input 4 and the transistor output 9 through the first transistor 2. The second output current sensor 11 is configured to measure the current conducted between the power input 4 and the transistor output 9 through the second transistor 3. The respective first and second output current sensor 10, 11 may comprise a thermistor. The voltage difference over the thermistor is proportional to the current running through and may be used as input to the control circuitry 7.

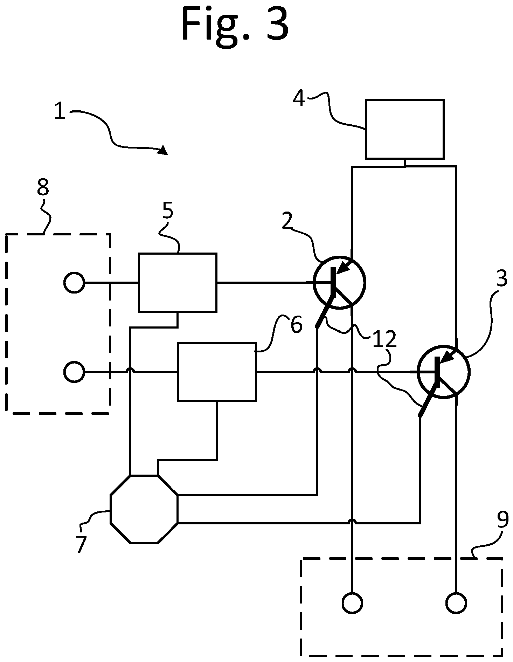

As illustrated in connection with Fig. 3 a junction temperature sensor 12 may be used for measuring and determining a respective current through the first and second transistors 2, 3. The junction temperature sensor 12 is configured to measure a temperature of a junction in the first transistor 2. The junction temperature sensor 12 is further configured to measure a temperature of a junction in the second transistor 3. Hence, the junction temperature sensor 12 may be a single junction temperature sensor 12 measuring the junction temperature of both the first transistor 2 and the second transistor 3. However, as readily understood, the junction temperature sensor 12 may also be embodied as comprising individual sensors for the first transistor 2 and the second transistor 3, respectively. The current conducted between the power input 4 and the transistor output 9 through the first transistor 2 and the current conducted between the power input 4 and the transistor output 9 through the second transistor 3 may then be determined based on the junction temperature of each respective transistor 2, 3. This determination may be done directly by the junction temperature sensor 12 or by the control circuitry 7. The control circuitry 7 may subsequently control the first gate voltage controller 5 and the second gate voltage controller 6 based on the current through the first transistor 2 and the second transistor 3, respectively.

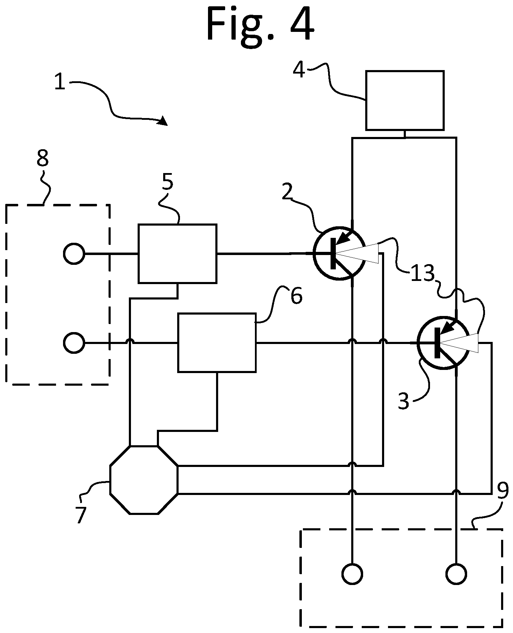

As illustrated in connection with Fig. 4 an input current sensor 13 may be used for measuring and determining a respective current through the first and second transistors 2, 3. The input current sensor 13 is configured to measure the current conducted between the power input 4 and the transistor output 9 through the first transistor 2 and the second transistor 3, respectively. The input current sensor 13 may be a single input current sensor 13 measuring current in both the first transistor 2 and the second transistor 3. Alternatively, input current sensor 13 may comprise be individual sensors for the first transistor 2 and the second transistor 3. According to one example, and being illustrated in Fig. 4, the input current sensor 13 comprises a Kelvin contact for the first transistor 2 and another Kelvin contact for the second transistor 3. A Kelvin contact is an additional source pin for measurement of the source current. A Kelvin contact may be used to measure the current similar to a 4-point probe measurement.

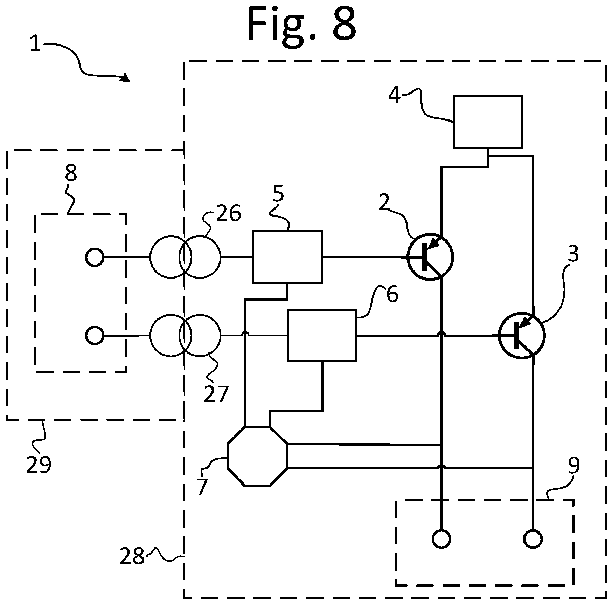

As illustrated in fig. 8, charging of the respective gate of the first and second transistors 2, 3 may be implemented with a respective gate drive transformer. Hence, the drive circuit 1 may further comprise a first gate drive transformer 26 and a second gate drive transformer 27. The first and second gate drive transformers 26, 27 are configured to independently charge a respective gate voltage of the first transistor 2 and the second transistor 3. The first and second gate drive transformers 26, 27 may each comprise a primary winding and a secondary winding. This will provide magnetic isolation between high power circuitry 28 and low power circuitry 29 of the drive circuit 1. The primary and secondary windings may be wound on a common ferromagnetic core. This protects the low power circuitry 29 from any damage due to faults on the high-power circuitry 28. Propagation delay is about 7-8 ns for magnetic isolation, whereas it is 50 ns for capacitive and 105 ns for optical isolation. Hence, it is understood that the magnetic isolation is advantageous at high frequency operation, e.g. above 200 kHz.

Furthermore, the first and second gate drive transformers 26, 27 each may comprise a primary side coupling capacitor and a secondary side coupling capacitor. Such coupling capacitor may block Direct Current voltage across the respective gate drive transformer 26, 27.

The drive circuit 1 may further comprise a primary resistor and a Zener diode. primary resistor and a Zener diode provide for protection of the gate when gate voltage is higher than a maximum rating of the first and second transistor 2, 3. Hence, the primary resistor and the Zener diode may protect the transistors 2, 3 from overvoltage.

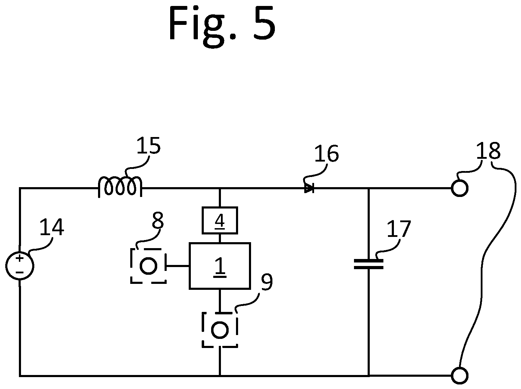

Fig. 5 illustrates a boost converter comprising a DC input 14 connected at a positive terminal to one end of an inductor 15. The other end of the inductor 15 is connected to the drive circuit 1 via the power input 4, and the diode 16, The drive circuit 1 is controlled by the gate input 8, to allow current to flow from the power input 4 to the transistor output 9. The boost converter further comprises a capacitor 17 connected to the diode 16 and the converter output 18.

The first transistor 2 and the second transistor 3 may be GaN-based transistors. GaN transistors have upper limits on the current-handling capability of a single device on the order of ~50 - 100 A. Above a certain die size, larger die size scaling leads to a reduction in the drain current i.e. current collapse. For example, if each of the GaN transistors is giving 100 A current, two parallel devices may give 200 A. For an ON-resistance of 200 mΩ of each of the two GaN devices, the parallel total ON-resistance is 100 mΩ. Four GaN transistors in parallel may give 400A etc. Since each transistor will have practical tolerances on the ON-resistances, and due to dynamic $R_{ds(on)}$; two GaN devices, with the same $R_{ds(on)}$

rating may not share current equally causing one of the transistors to take more current than the other, which may impact reliability of the circuit. For two parallel transistors the total dynamic ON-resistance is given by the below expression:

$$R_p = \left( \frac{1}{R_{1_{ON}}(t)} + \frac{1}{R_{2_{ON}}(t)} \right)^{-1}$$

For N parallel GaN transistors in parallel the dynamic ON-resistance is:

$$R_p = \left( \sum_{i=1}^{N} \frac{1}{R_{i_{ON}}(t)} \right)^{-1}$$

The current through the N number of GaN devices in parallel is:

$$I = \frac{V}{R_p(t)}.$$

Similarly, the power handling is scaled as $I^2 R_p$.

As discussed above, the inventor has realized that at switching frequencies above 200 kHz it is possible to control the dynamic current sharing between parallel GaN transistors for higher efficiency rather than limiting the frequency and slowing down the GaN transistors to enable current sharing without faulty operation.

GaN based transistors are desirable for parallel configurations due to steady threshold voltage over a wide temperature range and positive temperature coefficient of the ON-resistance. Due to the positive temperature coefficient of GaN based transistors; the current through the GaN based transistors are reduced when the junction temperature of the GaN based transistors are increased. Without parasitic device characteristics, the ON-resistance alone may enable current sharing between GaN based transistors. However, in practice unbalanced in-circuit parasitic between parallel devices leads to uneven sharing and degraded electrical and thermal performance, limiting the effectiveness of paralleling transistors. To evaluate the current distribution in parallel transistors it has herein been discussed to measure the current trough the individual transistors and control the gate voltage thereon.

High frequency operation of, i.e. above 200 kHz, of GaN based transistors, is limited by ringing current oscillations during transistor turn-on and turn-off, that may cause faulty device turn-on and shoot-through between high power side and low power side circuitry, e.g. in half-bridge configuration. Very fast rise and fall times of GaN based transistors on the order of 5 ns, requires low parasitic inductance of the GaN based transistors themselves but also its packaging. Preferably, the GaN based transistors are parallelized with a common source contact monolithically, with separate gate contacts to reduce parasitic inductance of bond wires between GaN based transistors. Each of the GaN based transistors may be isolated from each other by ion-implantation causing the GaN to become resistive.

A high positive slew rate, dv/dt from the drain relative to the source may lead to current paths that charges the parasitic capacitances Cgs, Cgd, and Cds of the GaN based transistor. Similarly, in other words the input capacitance (Ciss=Cgd+Cgs), the output capacitance (Coss=Cds+Cgd) and the reverse transfer capacitance (Crss=Cgd). This may cause the gate-source capacitance Cgs to charge above the threshold voltage, Vth, and hence turn-on the GaN based transistor. The threshold voltage of pGaN Schottky gate contacts, is typically 1-1.5 V.

The transient of the current, di/dt may limit the practical switching frequency of a GaN based transistor. Typically, the turn-on of a complementary device during off-state body diode conduction will induce a voltage step for the gate loop. Without damping of the off-state gate-loop LCR resonant tank, this may introduce ringing and may even cause faulty turn-on of the GaN based transistor itself. For GaN based transistors, the relatively high switching speeds amplify the impact of parasitic mismatches. Considerations must be made to three main parasitic inductances for common source inductance (CSI), the resonant loop formed between the gate driver and the GaN based transistor; and the gate loop with the current path from gate of the GaN based transistor to the source of the GaN based transistor. The drive circuit presented herein presents a solution to this.

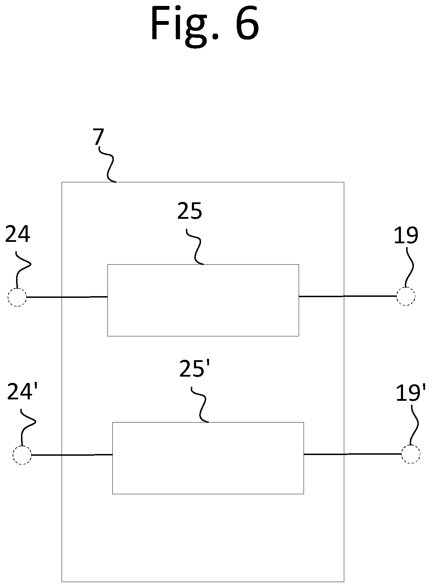

Fig. 6 illustrates a control circuitry 7 implemented by a first PID regulator 25 and a second PID regulator 25'. The first PID regulator 25 operates by receiving a first measurement 19 indicative of a current conducted through a first transistor 2. The first PID regulator 25 then processes the first measurement 19 and outputs a first control signal 24 for controlling the first variable gate voltage controller 5. The second PID regulator 25' operates in a similar manner to the first PID regulator 25. In other words, the second PID regulator 25' operates by receiving a second measurement 19' indicative of a current conducted through a second transistor 3. The second PID regulator 25' then processes the second measurement 19' and outputs a second control signal 24' for controlling the second variable gate voltage controller 6.

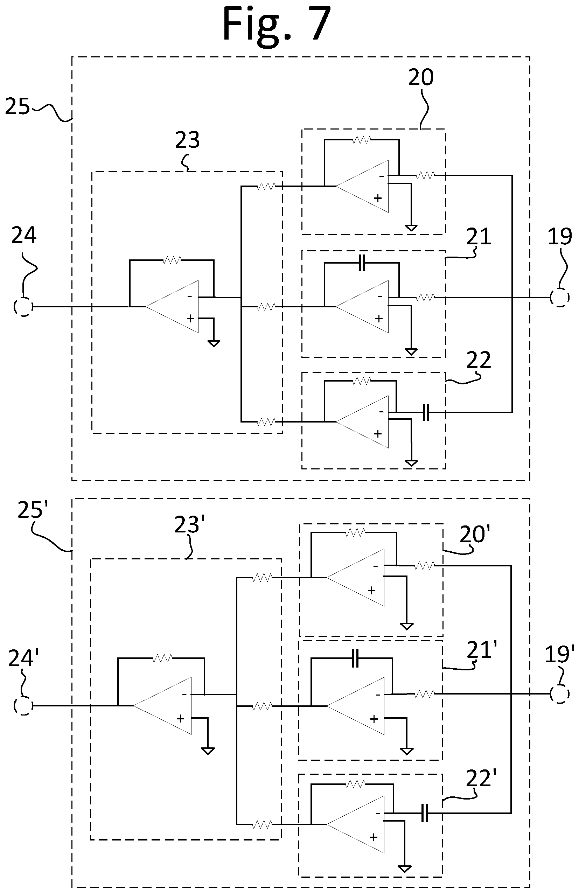

As illustrated in fig. 7, the first PID regulator 25 and the second PID regulator 25' may be implemented using operational amplifiers (OpAmps). The first PID regulator 25 comprises a first proportional controller 20, a first integral controller 21, and a first differential controller 22, where all three are connected in parallel. The first PID regulator 25 further comprises a first three-way adding circuit 23. The first PID regulator 25 operates by receiving a first measurement 19 indicative of a current conducted through a first transistor 2. The first proportional controller 20, the first integral controller 21, and the first differential controller 22 all receive and process the first measurement 19 individually. The result of the processing of the first measurement 19 by the first proportional controller 20, the first integral controller 21, and the first differential controller 22 is then received by the first three-way adding circuit 23. The first three-way adding circuit 23 subsequently generates a first control signal 24 for controlling the first gate voltage controller 5. The second PID regulator 25' operates in a similar manner to the first PID regulator 25. In other words, the second PID regulator 25' comprises a second proportional controller 20', a second integral controller 21', and a second differential controller 22', where all three are connected in parallel. The second PID regulator 25' further comprises a second three-way adding circuit 23'. The second PID regulator 25' operates by receiving a second measurement 19' indicative of a current conducted through a second transistor 3. The second proportional controller 20', the second integral controller 21', and the second differential controller 22' all receive and process the second measurement 19' individually. The result of the processing of the second measurement 19' by the second proportional controller 20', the second integral controller 21', and the second differential controller 22' is then received by the second three-way adding circuit 23'. The second three-way adding circuit 23' subsequently generates a second control signal 24' for controlling the second gate voltage controller 6.

Further, a PID regulator, with a Proportional Op amp, an Integrator Op amp, and a Differential Op amp, as well as a three-way adding Op amp. For example, the Op amp, LM741, may have a gain of 200V/mV i.e. 200 000. If the power supply to the Op amp is 12V, a differential voltage across the Op amp input may be 61 $\mu$V. Hence, the Op amp may control a variable gate resistor based on the sensitivity of 61 $\mu$V difference.

The person skilled in the art realizes that the present invention by no means is limited to what is explicitly described above. On the contrary, many modifications and variations are possible within the scope of the appended claims.

For example, the thermistor(s) used for the output current sensor(s) (10, 11) is/are preferably a Positive Temperature Coefficient, PTC, thermistor(s). This since PTC thermistors are more sensitive than Negative Temperature Coefficient, NTC, thermistors at the relatively high temperatures being temperatures applicable for the current drive circuit 1. The thermistor may be configured to withstand high temperatures up to 300°C-500°C. The thermistor may be a DO-35 glass encapsulated thermistor that are hermetically sealed devices capable of withstanding temperatures up to 300°C. The thermistor may be a Semitec NTC thermistor that can withstand temperatures up to 500°C.

Additionally, variations can be understood and effected by the skilled person in practicing the claimed invention, from a study of the drawings, the disclosure, and the appended claims.

Reference list

| 1 | Drive circuit |
|---|---|
| 2 | First transistor |
| 3 | Second transistor |
| 4 | Power input |
| 5 | First gate voltage controller |
| 6 | Second gate voltage controller |
| 7 | Control circuitry |
| 8 | Gate input |
| 9 | Transistor output |
| 10 | First output current sensor |
| 11 | Second output current sensor |
| 12 | Junction temperature sensor |
| 13 | Input current sensor |
| 14 | DC input |
| 15 | Inductor |
| 16 | Diode |
| 17 | Capacitor |
| 18 | Converter output |
| 19 | First current measurement |
| 19' | Second current measurement |
| 20 | First proportional controller |
| 20' | Second proportional controller |
| 21 | First integral controller |
| 21' | Second integral controller |
| 22 | First differential controller |
| 22' | Second differential controller |
| 23 | First three-way adding circuit |
| 23' | Second three-way adding circuit |
| 24 | First control signal |
| 24' | Second control signal |
| 25 | First PID regulator |
| 25' | Second PID regulator |
| 26 | First gate driver transformer |
| 27 | Second gate drive transformer |
| 28 | High power circuitry |
| 29 | Low power circuitry |

**Claims**

1.  A drive circuit (1) for a power converter, the drive circuit (1) comprising:

    a first transistor (2) and a second transistor (2) electrically connected in parallel having a common power input (4) and individual gates;
    a first variable gate voltage controller (5) connected to the gate of the first transistor (2);
    a second variable gate voltage controller (6) connected to the gate of the second transistor (3);
    control circuitry (7) configured to independently control an impedance of the first and second variable gate voltage controllers (5, 6) based on a current through the respective first and second transistor (2, 3) to control the current through the respective first and second transistor (2, 3).

2. The drive circuit (1) according to claim 1, wherein the control circuitry (7) independently controls the impedance of the first and second variable gate voltage controllers (5, 6) by controlling a respective resistance of the first variable gate voltage controller (5) and second variable gate voltage controller (6).

3. The drive circuit (1) according to claim 1 or 2, wherein the impedance of the first and second variable gate voltage controllers (5, 6) are controlled such that a difference between the respective current through the first and second transistor (2, 3) is minimized.

4. The drive circuit (1) according to any one of claims 1-3, wherein the first transistor (2) and the second transistor (3) each has a switching frequency above 200 kHz.

5. The drive circuit (1) according to any one of claims 1-4, wherein the first transistor (2) and the second transistor (3) are GaN-based transistors.

6. The drive circuit (1) according to any one of claims 1-5, wherein the first transistor (2,) and the second transistor (3) comprises a common input contact monolithically.

7. The drive circuit (1) according to any one of claims 1-6, wherein the control circuitry (7) comprises a first PID regulator (25) and a second PID regulator (26), wherein the first PID regulator (25) is configured to control the impedance of the first variable gate voltage controller (5) based on the current through the first transistor (2) and wherein the second PID regulator (26) is configured to control the impedance of the second variable gate voltage controller (6) based on the current through the second transistor (3).

8. The drive circuit (1) according to claim 7, wherein one or both of the first PID regulator (25) and the second PID regulator (26) comprises four operational amplifiers (20, 21, 22, 23), wherein three (20, 21, 22) of the four operational amplifiers comprise a common input (19, 19') and wherein one (23) of the four operational amplifiers comprises an input receiving an output of each one of the three operational amplifiers and an output (24, 24') to control the respective first and second variable gate voltage controller (5, 6).

9. The drive circuit according to any one of claims 1-8, further comprising a junction temperature sensor (12) configured to measure a first junction temperature of a first junction of the first transistor (2) and a second junction temperature of a second junction of the second transistor (3); and wherein the current through the first transistor (2) is determined based on the first junction temperature and the current through the second transistor (3) is determined based on the second junction temperature.

10. The drive circuit according to any one of claims 1-9, further comprising an output current sensor (10, 11) configured to determine the current through the first transistor and the current through the second transistor.

11. The drive circuit according to claim 9, wherein the output current sensor (10, 11) comprises a thermistor.

12. The drive circuit (1) according to any one of claims 1-11, further comprising an input current sensor (13) configured to determine the current through the first transistor (2) and the current through the second transistor (3).

13. The drive circuit according to claim 12, wherein the first transistor (2) and the second transistor (3) each comprises a kelvin contact, wherein the kelvin contact is the input current sensor (13).

14. A power converter system comprising the drive circuit according to any one of claims 1-13.

15. A power module comprising one or more power converter systems according to claim 14.

# Fig. 1

# Fig. 2

# Fig. 3

# Fig. 4

# Fig. 5

# Fig. 6

# Fig. 7

# Fig. 8

Europäisches
Patentamt
European
Patent Office
Office européen
des brevets

## EUROPEAN SEARCH REPORT

**Application Number**

EP 24 20 8625

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/150609 A1 (DURBAUM THOMAS [DE]) 26 June 2008 (2008-06-26) | 1-6,9-15 | INV. H03K17/12 H03K17/16 |
| Y | * figure 1 * | 7 | |
| A | | 8 | |
| | ----- | | |
| X | EP 2 911 191 A2 (BOEING CO [US]) 26 August 2015 (2015-08-26) | 1-7,9, 14,15 | |
| Y | * figure 4 * | 8 | |
| A | | 10-13 | |
| | ----- | | |
| Y | Theophilus E E ET AL: "Design of Analog PID Controller", JOURNAL OF ADVANCEMENT IN ENGINEERING AND TECHNOLOGY, 15 October 2018 (2018-10-15), pages 1-8, XP093260546, Retrieved from the Internet: URL:www.scienceq.org/JAET.php [retrieved on 2025-03-18] * figure 2 * | 7,8 | |
| | ----- | | |

**TECHNICAL FIELDS SEARCHED (IPC)**

H03K

The present search report has been drawn up for all claims

| Place of search | Date of completion of the search | Examiner |
|---|---|---|
| The Hague | 18 March 2025 | Simon, Volker |

EPO FORM 1503 03.82 (P04C01)

**EP 4 734 371 A1**

## ANNEX TO THE EUROPEAN SEARCH REPORT
## ON EUROPEAN PATENT APPLICATION NO.

EP 24 20 8625

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2025

| Patent document cited in search report | Publication date | Patent family member(s) | Publication date |
|---|---|---|---|
| US 2008150609 A1 | 26-06-2008 | EP 1656735 A2 | 17-05-2006 |
| | | JP 2007502569 A | 08-02-2007 |
| | | KR 20060060018 A | 02-06-2006 |
| | | US 2008150609 A1 | 26-06-2008 |
| | | WO 2005015741 A2 | 17-02-2005 |
| EP 2911191 A2 | 26-08-2015 | BR 102015002978 A2 | 10-02-2016 |
| | | CA 2876122 A1 | 24-08-2015 |
| | | CN 104865988 A | 26-08-2015 |
| | | EP 2911191 A2 | 26-08-2015 |
| | | JP 6560865 B2 | 14-08-2019 |
| | | JP 2015159712 A | 03-09-2015 |
| | | KR 20150100535 A | 02-09-2015 |
| | | US 9046912 B1 | 02-06-2015 |

For more details about this annex : see Official Journal of the European Patent Office, No. 12/82